# EUROPÄISCHE PATENTSCHRIFT

(11) **EP 0 694 840 B1**
(45) Veröffentlichungstag und Bekanntmachung des Hinweises auf die Patenterteilung: **17.10.2001**
(21) Anmeldenummer: 95110472.8
(22) Anmeldetag: 05.07.1995
(51) Int. Cl.: G06F 11/00

(54) **Kraftfahrzeug-Steuergerät mit elektrisch lösch- und programmierbarem Speicher**
Motor vehicle controller using electrically erasable and programmable memory
Dispositif de contrôle pour véhicule à moteur avec mémoire effaçable et programmable électriquement

(30) Priorität: 30.07.1994 DE 4427108
(43) Veröffentlichungstag der Anmeldung: 31.01.1996
(73) Patentinhaber: ROBERT BOSCH GMBH, 70442 Stuttgart (DE)
(72) Erfinder: Tauscher, Joachim, Dipl.-Ing. (BA), D-70499 Stuttgart (DE); Laichinger, Martin, Dipl.-Ing., D-73061 Ebersbach (DE); Karlheinz, Frank, Dipl.-Ing., D-71334 Waiblingen (DE)

(56) Entgegenhaltungen:
- EP-A- 0 412 039
- WO-A-92/19046
- DE-A- 4 230 615

## Beschreibung

### Stand der Technik

Die Erfindung geht aus von einem Kraftfahrzeug-Steuergerät nach der Gattung des Hauptanspruchs. Es ist schon ein Kraftfahrzeug-Steuergerät aus der DE 42 30 615 A1 bekannt. Das darin beschriebene Kraftfahrzeug-Steuergerät enthält einen Mikrorechner und einen elektrisch lösch- und programmierbaren Speicher (EEPROM). Der elektrisch lösch- und programmierbare Speicher dient dort als Fehlerspeicher. Der Fehlerspeicher ist in zwei verschiedene Speicherbereiche eingeteilt. In den ersten Speicherbereich werden die Fehlerworte eingetragen. In den zweiten Speicherbereich wird jeweils eine Checksumme eingetragen, anhand derer der Fehlerspeicher überprüft werden kann. Für den Zugriff zu der aktuellen Fehlerspeicherzelle und der aktuellen Speicherzelle für die Checksumme wird ein Offset-Zeiger verwendet. Wenn zwischen Checksumme und Fehlereintrag eine Diskrepanz besteht, wird der Offset-Zeiger inkrementiert und es wird sowohl eine neue Speicherzelle für die Fehlereinträge als auch für die Checksumme ausgewählt. Damit wird sichergestellt, daß die als defekt erkannten Zellen für die weiteren Abspeichervorgänge nicht mehr benutzt werden.

### Vorteile der Erfindung

Das erfindungsgemäße Kraftfahrzeug-Steuergerät mit den kennzeichnenden Merkmalen des Hauptanspruchs hat demgegenüber den Vorteil, daß Mittel vorhanden sind, die den Adreßzeiger nach Inkrementierung oder Dekrementierung mit einer bestimmten binären Zahl logisch verknüpfen. Dadurch kann der Speicherbereich, der über den Adreßzeiger ansprechbar ist, auf eine gewünschte Größe beschränkt werden. Selbst wenn der Speicherplatz, an dem der Adreßzeiger abgespeichert ist, vor der Inkrementierung oder Dekrementierung einen fehlerhaften Eintrag aufweist, kann nur eine Speicherzelle innerhalb des begrenzten Speicherbereiches angesprochen werden. Dadurch ist die Sicherheit des Kraftfahrzeug-Steuergerätes erhöht.

Die Erfindung, die durch Anspruch 1 definiert wird, kann vorteilhaft bei einem Diebstahlschutz-Steuergerät angewendet werden. Als Information wird dabei eine Vorfreigabezeit auf einen Speicherplatz des elektrisch lösch- und programmierbaren Speichers eingetragen. Die Vorfreigabezeit wird bei jeder Inbetriebnahme um einen bestimmten Betrag reduziert, wenn eine Berechtigungsprüfung nicht bestanden wurde. Durch die Maßnahmen gemäß Anspruch 5 wird jetzt verhindert, daß das Kraftfahrzeug selbst dann nicht unberechtigt betrieben werden kann, wenn die Speicherzelle in dem lösch- und programmierbaren Speicher, an der die Vorfreigabezeit abgespeichert ist, einen Defekt aufweist.

### Zeichnung

Ein Ausführungsbeispiel der Erfindung ist in der Zeichnung dargestellt und in der nachfolgenden Beschreibung näher erläutert. Es zeigen Figur 1 ein Blockschaltbild einer Wegfahrsperre eines Kraftfahrzeuges; Figur 2 ein Flußdiagramm für ein Magnetventil-Steuergerät der Wegfahrsperre; Figur 3 Speichereinträge in den elektrisch lösch- und programmierbaren Speicher zu drei verschiedenen Zeitpunkten; und Figur 4 die Bedeutung der zulässigen Bitmuster für die Vorfreigabezeit des Magnetventil-Steuergerätes in tabellarischer Form.

### Beschreibung der Erfindung

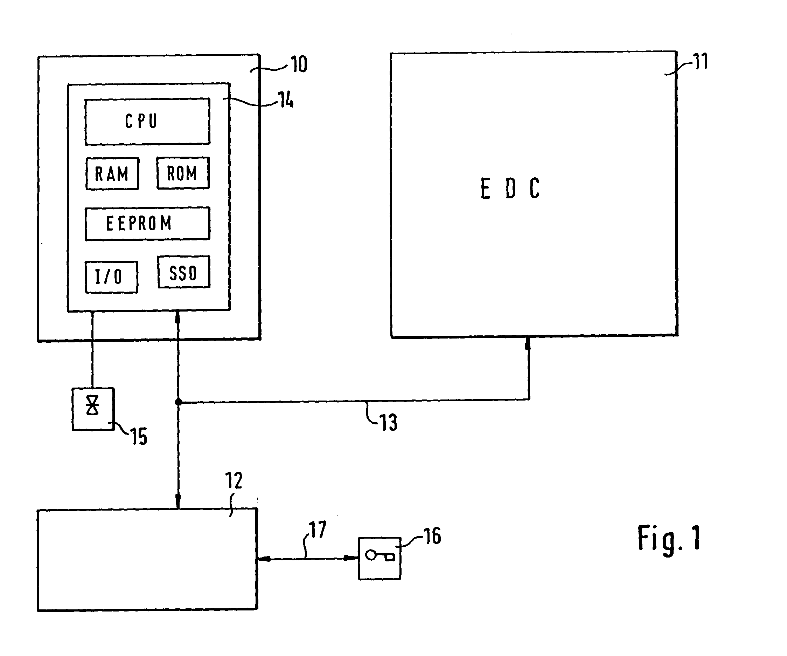

In Figur 1 bezeichnet die Bezugszahl 10 ein Magnetventil-Steuergerät. An das Magnetventil-Steuergerät 10 ist über eine serielle Datenübertragungsleitung 13 ein Einspritz-Steuergerät 11 und ein Immobilizer 12 angeschlossen. Das Einspritz-Steuergerät 11 dient zur Steuerung der Einspritzung des Dieselkraftstoffs bei einer Brennkraftmaschine. Mit Hilfe des Immobilizers 12 wird eine Wegfahrsperre für das Kraftfahrzeug, in dem die genannten Steuergeräte verbaut sind, gebildet. Sowohl das Einspritz-Steuergerät 11 als auch das Magnetventil-Steuergerät 10 erwarten nämlich nach Inbetriebnahme einen Berechtigungscode von dem Immobilizer 12. Nur wenn der korrekte Code empfangen wurde, nehmen die Steuergeräte 10 und 11 ihren eigentlichen Betrieb auf. Das Magnetventil-Steuergerät 10 hat dabei lediglich die Funktion, daß es durch Betätigung des angeschlossenen Magnetventils 15 die Kraftstoffzufuhr zu der Dieselpumpe freigibt, wenn der korrekte Code von dem Immobilizer 12 empfangen wurde. Das Magnetventil-Steuergerät dient damit als Diebstahlschutz-Steuergerät. An den Immobilizer 12 ist eine Eingabeeinheit 16 angeschlossen. In dieser Eingabeeinheit kann ein codierter Schlüssel eingesteckt werden. Über die Übertragungsstrecke 17 wird der Code des Schlüssels zu dem Immobilizer 12 übertragen. Der Immobilizer 12 erkennt anhand dieses Codes, ob eine berechtigte Inbetriebnahme des Kraftfahrzeuges vorliegt oder nicht. Der Berechtigungscode kann dabei auch drahtlos mit Hilfe eines Sendegerätes zu dem Immobilizer 12 übertragen werden. Der genauere Aufbau des Immobilizers 12 als auch des Einspritz-Steuergerätes 11 ist für die hier beschriebene Erfindung nicht relevant und es wird daher im folgenden hierauf nicht näher eingegangen.

Der Aufbau des Magnetventil-Steuergerätes 10 ist in Figur 1 genauer dargestellt. In dem Magnetventil-Steuergerät 10 ist ein Mikrorechner 14 enthalten. Dieser besteht aus einer Zentraleinheit CPU, einem flüchtigen Speicher RAM, einem Nur-Lese-Speicher ROM, einem elektrisch lösch- und programmierbaren Speicher EEPROM, einer Ein/Ausgabeeinheit I/O und einer seriellen Schnittstelle SS0. Die genannten Komponenten des Mikrorechners 14 sind auf einem Chip integriert. Sie könnten jedoch auch auf verschiedenen Chips integriert sein oder auch als diskrete Bauelemente vorliegen.

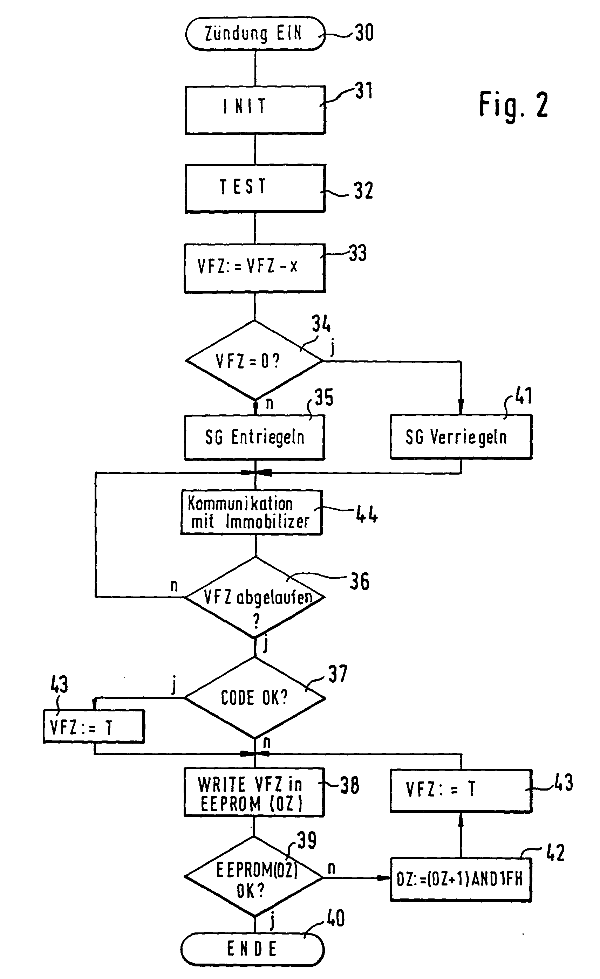

Nachfolgend wird die Arbeitsweise des Magnetventil-Steuergerätes 10 anhand der Figur 2 näher erläutert. Das Steuerprogramm des Magnetventil-Steuergerätes ist im Nur-Lese-Speicher ROM abgespeichert. Im Programmschritt 30 wird die Zündung für das Kraftfahrzeug eingeschaltet. Daraufhin wird also das Programm im Magnetventil-Steuergerät 10 gestartet. Im Programmschritt 31 erfolgt eine Initialisierung des Magnetventil-Steuergerätes 10. Im anschließenden Programmschritt 32 führt der Mikrorechner 14 des Magnetventil-Steuergerätes 10 einen Selbsttest durch. Im Programmschritt 33 liest die Zentraleinheit CPU die erste Speicherstelle eines vordefinierten Speicherbereiches innerhalb des elektrisch lösch- und programmierbaren Speichers EEPROM aus. Sie entnimmt aus dieser Speicherstelle einen Code für die Vorfreigabezeit VFZ für das Magnetventil-Steuergerät 10. Die entnommene Vorfreigabezeit VFZ wird um einen vorgegebenen Wert X reduziert. Dies geschieht ebenfalls im Programmschritt 33. In Abfrage 34 wird dann überprüft, ob der Wert für die Vorfreigabezeit VFZ den Wert Null erreicht hat. Wenn dies der Fall ist, wird das Steuergerät, d.h. das Magnetventil 15 im Programmschritt 41 verriegelt. Damit ist die Kraftstoffzufuhr zu der Dieselpumpe unterbunden. Danach wird das Programm mit Programmschritt 44 fortgeführt. War die Vorfreigabezeit VFZ in Abfrage 34 noch nicht als Null erkannt, dann wird im Programmschritt 35 das Magnetventil-Steuergerät entriegelt. Das heißt die Kraftstoffzufuhr zur Dieselpumpe wird freigegeben. Die bedingungslose Freigabe der Kraftstoffzufuhr ohne vorherige Überprüfung des Berechtigungscodes hat den Sinn, daß der Betrieb des Kraftfahrzeuges sehr schnell erneut gestartet werden kann. Wenn z.B. das Kraftfahrzeug bei Abwürgen der Brennkraftmaschine oder nach Abschaltung an einer Ampel wieder gestartet werden soll, ist dies von besonderem Vorteil. Es soll dann nämlich ein Schnellstart möglich sein, der nicht erst durch die längere Kommunikation mit dem Immobilizer 12 verzögert werden soll.

In Programmschritt 44 findet nachfolgend die Kommunikation mit dem Immobilizer 12 statt. In Abfrage 36 wird dann überprüft, ob die Vorfreigabezeit VFZ schon abgelaufen ist. Wenn das nicht der Fall ist, wird erneut Programmschritt 44 aufgerufen, so lange, bis die Vorfreigabezeit VFZ abgelaufen ist. Wenn die Vorfreigabezeit abgelaufen ist, wird in Abfrage 37 überprüft, ob der von dem Immobilizer 12 empfangene Code korrekt ist. Wenn dies nicht der Fall ist, wird jetzt im Programmschritt 38 die im Programmschritt 33 neu berechnete Vorfreigabezeit VFZ auf den ersten Speicherplatz des vordefinierten Speicherbereiches innerhalb des elektrisch lösch- und programmierbaren Speichers EEPROM einprogrammiert. Andernfalls wird die Vorfreigabezeit VFZ im Programmschritt 43 auf den Maximalwert T gesetzt.

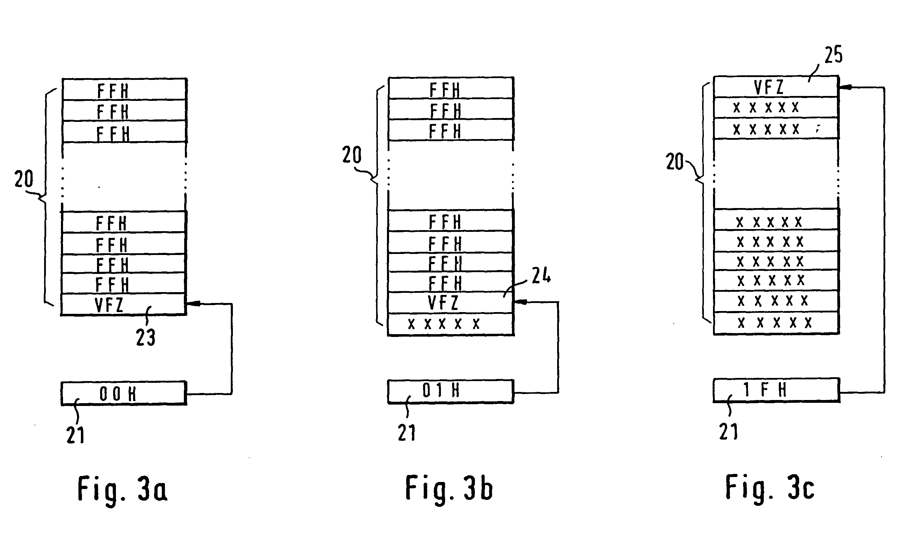

Zu den Programmschritten 33 und 38 ist noch zu erwähnen, daß der Zugriff zu der Speicherstelle, in der die Vorfreigabezeit VFZ abgespeichert ist, über einen Offset-Zeiger OZ erfolgt. Dies ist in Figur 3 dargestellt. Darin bezeichnet die Bezugszahl 20 den vordefinierten Speicherbereich für die Vorfreigabezeit VFZ. Es sind hierfür mehrere Speicherplätze vorgesehen, obwohl die Vorfreigabezeit VFZ nur in einem einzelnen Speicherplatz 23 abgespeichert ist. In Figur 3a ist die Situation dargestellt, daß nur der erste Speicherplatz 23 des vordefinierten Speicherbereiches 20 mit der Vorfreigabezeit belegt ist. Die restlichen Speicherplätze des vordefinierten Speicherbereiches 20 enthalten die hexadezimale Zahl FFH. Dies bedeutet, daß die restlichen Speicherplätze des vordefinierten Speicherbereiches noch unprogrammiert sind. Die restlichen Speicherplätze dienen als Sicherheitsreserve. Es kann nämlich im Laufe des Betriebes des Kraftfahrzeuges vorkommen, daß der erste Speicherplatz des vordefinierten Speicherbereiches sehr häufig umprogrammiert wird. Wenn eine bestimmte Zahl von Umprogrammierungen überschritten ist (die Zahl liegt in der Größenordnung von 10 000 bis 50 000) kann es vorkommen, daß der erste Speicherplatz einen Defekt aufweist und nicht mehr ordnungsgemäß umprogrammiert werden kann. In diesem Fall wird der Offset-Zeiger OZ, der in dem Speicherplatz 21 abgespeichert ist, inkrementiert. Es wird dann automatisch der nächsthöhere Speicherplatz für die Abspeicherung der Vorfreigabezeit VFZ verwendet. Da die nächsthöhere Speicherstelle des vordefinierten Speicherbereiches 20 zuvor nicht genutzt wurde, handelt es sich um eine "frische" Speicherstelle, und es können weiterhin häufige Umprogrammierungen dieser Speicherstelle vorgenommen werden.

In Figur 3a ist ein Zeitpunkt dargestellt, bei dem der Speicherplatz 21 für die Abspeicherung des Offset-Zeigers OZ den Wert OOH aufweist. Damit wird zur ersten Speicherstelle 23 des vordefinierten Bereiches 20 zugegriffen. In Figur 3b ist ein Zeitpunkt dargestellt, bei dem der Speicherplatz 21 für die Abspeicherung des Offset-Zeigers OZ den Eintrag 01H aufweist. Es wird also zu der zweiten Speicherstelle 24 des vordefinierten Speicherbereichs 20 zugegriffen. Die erste Speicherstelle 23 des vordefinierten Speicherbereiches weist einen Defekt auf und wird nicht mehr für die Abspeicherung der Vorfreigabezeit VFZ verwendet. In Figur 3c ist schließlich ein Zeitpunkt dargestellt, an dem in den Speicherplatz 21 für den Offset-Zeiger OZ der Wert 1FH eingetragen wurde. Damit greift der Mikrorechner für die Abspeicherung der Vorfreigabezeit VFZ auf den letzten Speicherplatz 25 des vordefinierten Speichersbereiches 20 zu. Alle anderen Speicherplätze des vordefinierten Speicherbereiches 20 weisen Defekte auf.

Die Überprüfung der Speicherstelle 23,24,25 für die Abspeicherung der Vorfreigabezeit VFZ geschieht gemäß Figur 2 im Programmschritt 39. Wie diese Überprüfung im einzelnen durchgeführt wird, darauf wird nachfolgend noch genauer eingegangen werden. Wenn kein Fehler bei der Speicherstelle 23,24,25 entdeckt werden konnte, wird das Programm in Programmschritt 40 beendet. Wenn ein Fehler erkannt wurde, wird in Programmschritt 42 der Offset-Zeiger OZ inkrementiert und nachfolgend das Ergebnis der Inkrementierung mit dem hexadezimalen Wert 1FH logisch UND-verknüpft. Durch die logische UND-Verknüpfung wird erreicht, daß der Offset-Zeiger OZ keinen größeren Wert annehmen kann, als den angegebenen Wert 1FH. Damit ist die Größe des vordefinierten Speicherbereiches 20 für die Abspeicherung der Vorfreigabezeit VFZ fest vorgegeben. Selbst wenn bei der Inkrementierung ein größerer Wert entsteht, kann dieser Wert nicht in die Speicherstelle 21 für die Abspeicherung des Offset-Zeigers OZ eingetragen werden. Es werden nämlich durch die UND-Verknüpfung mit dem hexadezimalen Wert 1FH die obersten drei Bit des Offset-Zeiger-Wertes ausgeblendet. Nach dem Programmschritt 42 wird die Vorfreigabezeit VFZ auf den Maximalwert T gesetzt. Dies geschieht im Programmschritt 43. Damit wird bezweckt, daß nach dem Erkennen eines Defektes bei einer Speicherstelle innerhalb des vordefinierten Speicherbereiches 20 ein betriebssicherer Wert - in diesem Fall die maximale Vorfreigabezeit VFZ - ausgesucht wird. Der Eintrag in der defekten Speicherzelle ist nämlich nicht mehr verläßlich und es muß ein neuer Startwert für die Vorfreigabezeit VFZ vorgegeben werden. Nach dem Programmschritt 43 verzweigt das Programm wieder zum Programmschritt 38.

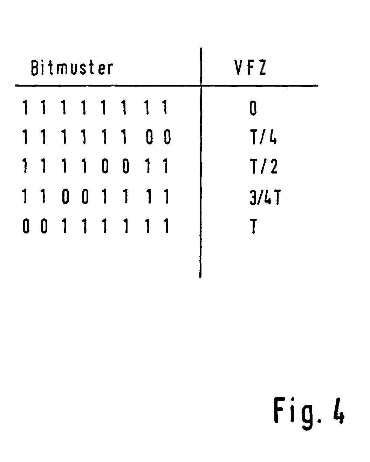

Anhand der Figur 4 wird jetzt erklärt, wie die Überprüfung der Speicherstellen 23,24,25 für die Abspeicherung der Vorfreigabezeit vor sich geht. Die Vorfreigabezeit VFZ wird in codierter Form in einem Byte des elektrisch lösch- und programmierbaren Speichers EEPROM abgelegt. In Figur 4 sind die zulässigen Bitmuster für eine gültige Vorfreigabezeit angegeben. In der Spalte daneben ist dann angegeben, welcher Vorfreigabezeit VFZ jedes Bitmuster entspricht. Dabei ist T die maximal mögliche Vorfreigabezeit. Es sind insgesamt nur fünf Bitmuster für die Vorfreigabezeit VFZ zulässig. Bei der Überprüfung der aktuellen Speicherstelle für die Abspeicherung der Vorfreigabezeit VFZ wird jetzt der Speicherinhalt der über den Offset-Zeiger OZ adressierten Speicherstelle ausgelesen und sukzessive mit den fünf zulässigen Bitmustern für die Vorfreigabezeit verglichen. Die zulässigen Bitmuster für die Vorfreigabezeit sind z.B. im Nur-Lese-Speicher ROM abgespeichert. Wenn der ausgelesene Speicherinhalt mit einem der zulässigen Bitmuster übereinstimmt, wird davon ausgegangen, daß kein Defekt bei der Speicherstelle für die Vorfreigabezeit vorliegt. Wenn jedoch der Speicherinhalt mit keinem der zulässigen Bitmuster übereinstimmt, wird davon ausgegangen, daß ein Defekt bei der Speicherstelle für die Vorfreigabezeit vorliegt. Da bloß fünf Bitmuster von 256 möglichen Bitmustern zulässig sind, ist also die Wahrscheinlichkeit sehr groß daß bei einem Defekt der aktuellen Speicherstelle für die Vorfreigabezeit ein unzulässiges Bitmuster ausgelesen wird und also nachfolgend bei dem Vergleich der Defekt erkannt wird. Mit anderen Worten ausgedrückt sind die zulässigen Bitmuster für die Vorfreigabezeit redundant ausgelegt. Aufgrund dieser Redundanz sind die Speicherinhalte wie hier beschrieben überprüfbar. Da bei jeder Umprogrammierung einer Speicherstelle des elektrisch lösch- und programmierbaren Speichers ein Löschvorgang dieser Speicherstelle durchgeführt werden muß, kann zusätzlich überprüft werden, ob die Speicherstelle tatsächlich nach dem Löschvorgang den Wert FFH aufweist. Wenn dies nicht der Fall ist, so kann schon nach dem Löschvorgang ein Defekt bei der Speicherstelle festgestellt werden.

Die Erfindung ist nicht auf das hier beschriebene Ausführungsbeispiel beschränkt. Sie kann immer dann eingesetzt werden, wenn z.B. in einem Kraftfahrzeug-Steuergerät eine Information auf einem elektrisch lösch- und programmierbaren Speicherplatz wiederholt in codierter Form abgelegt werden muß.

Zudem kann die Ausführung in einem beliebigen betriebsrelevanten Steuergerät für den Diebstahlschutz verwendet werden.

## Patentansprüche

1. Kraftfahrzeug-Steuergerät, mit einem Mikrorechner, mit einem elektrisch lösch- und programmierbaren Speicher, wobei zur vorübergehenden Speicherung einer Information ein redundantes Bitmuster auf wenigstens einem Speicherplatz des elektrisch lösch- und programmierbaren Speichers eingeschrieben ist, mit Mitteln zur Überprüfung des Speicherinhalts des mindestens einen Speicherplatzes anhand der Redundanz des Bitmusters, die in dem Fall, daß der mindestens eine Speicherplatz als defekt erkannt wird mindestens einen anderen Speicherplatz für die Abspeicherung der Information auswählen und ansonsten weiterhin den mindestens einen alten Speicherplatz für die Abspeicherung der Information benutzen, wobei der Zugriff auf den mindestens einen Speicherplatz (23,24,25) über einen Adreßzeiger (OZ), insbesondere Offset-Zeiger, erfolgt, wobei Mittel vorhanden sind, die nach Feststellung eines Defektes bei dem mindestens einen Speicherplatz (23,24,25) für die Abspeicherung der Information (VFZ) den Adreßzeiger (OZ) um einen vorgegebenen Wert inkrementieren oder dekrementieren, so daß der mindestens eine andere Speicherplatz (24,25) für die Abspeicherung der Information (VFZ) benutzt wird, **dadurch gekennzeichnet, daß** Mittel vorhanden sind, die den Adreßzeiger (OZ) nach Inkrementierung oder Dekrementierung mit einer vorbestimmten binären Zahl (1FH) logisch verknüpfen, insbesondere logisch UND-verknüpfen, so daß der Adreßzeiger (OZ) einen vorgegebenen Binärwert (1fH) nicht über- oder unterschreiten kann.

2. Kraftfahrzeug-Steuergerät nach Anspruch 1, **dadurch gekennzeichnet, daß** es als Diebstahlschutz-Steuergerät ausgelegt ist, das eine fahrzeugwichtige Funktion steuert, daß es Mittel aufweist, die die fahrzeugwichtige Funktion erst nach einer Berechtigungsprüfung freischalten, daß es weitere Mittel aufweist, die die fahrzeugwichtige Funktion bei Inbetriebnahme für eine Vorfreigabezeit freischalten, wobei die Vorfreigabezeit (VFZ) bei jeder Inbetriebnahme um einen bestimmten Betrag (X) reduziert wird, wenn die Berechtigungsprüfung nicht bestanden wurde, und daß die Vorfreigabezeit (VFZ) die Information darstellt, die auf dem mindestens einen Speicherplatz (23,24,25) des elektrisch lösch- und programmierbaren Speichers (EEPROM) eingespeichert ist.

## Claims

1. Motor vehicle controller, having a microcomputer with an electrically erasable and programmable memory, a redundant bit pattern being written onto at least one memory location of the electrically erasable and programmable memory in order to store information temporarily, having means for checking the stored content of the at least one memory location by means of the redundancy of the bit pattern, which, in the event of at least one memory location being detected as defective, select at least one other memory location for the storage of the information and otherwise continue to use the at least one old memory location to store the information, the access to the at least one memory location (23, 24, 25) being made via an address counter (OZ), in particular, an offset counter, means being provided which, after a defect is detected in the at least one memory location (23, 24, 25) for the storage of the information (VFZ), increment or decrement the address counter (OZ) by a predefined value, with the result that the at least one other memory location (24, 25) is used to store the information (VFZ), **characterized in that** means are provided which logically connect, in particular logically AND-connect, the address counter (OZ), after incrementation or decrementation, with a predetermined binary number (1FH) so that the address counter (OZ) cannot exceed or undershoot a predefined binary value (1fH).

2. Motor vehicle controller according to Claim 1, **characterized in that** it is configured as an anti-theft controller which controls a function which is important for the vehicle, **in that** it has means which enable the function which is important for the vehicle only after an authorization test, **in that** it has further means which enable the function which is important for the vehicle for a pre-enabling time when activation occurs, the pre-enabling time (VFZ) being reduced by a certain amount (X) whenever activation occurs if the authorization test has not been passed, and **in that** the pre-enabling time (VFZ) represents the information which is stored on the at least one memory location (23, 24, 25) of the electrically erasable and programmable memory (EEPROM).

## Revendications

1. Appareil de commande d'un véhicule automobile, comprenant
un micro-ordinateur équipé d'une mémoire programmable et effaçable électriquement, un modèle de bit redondant étant inscrit au moins à un emplacement de la mémoire programmable et effaçable électriquement, pour la mémorisation provisoire d'une information
des moyens pour vérifier le contenu de la mémoire d'au moins un emplacement de mémoire à l'aide de la redondance du modèle de bit qui, au cas où au moins un emplacement de mémoire est reconnu comme défectueux, sélectionne au moins un autre emplacement de mémoire pour recevoir l'information et, au cas contraire, utilise toujours au moins un ancien emplacement de mémoire pour enregistrer l'information,
l'accès à au moins un emplacement de mémoire (23, 24, 25) se faisant par un index d'adresses (OZ), notamment d'un index de décalage,
des moyens permettant, après avoir déterminé un défaut d'au moins un emplacement de mémoire (23, 24, 25) pour mémoriser l'information (VFZ), d'incrémenter ou de décrémenter d'une valeur prédéterminée, l'index d'adresses (OZ) pour qu'au moins un autre emplacement de mémoire (24, 25) soit utilisé pour recevoir l'information (VFZ),
caractériser par
des moyens qui effectuent une combinaison logique de l'index d'affichage (OZ) après incrémentation ou décrémentation, avec un nombre binaire prédéterminé (1fH), notamment une combinaison logique (ET) pour que l'index d'adresses (OZ) ne dépasse ni vers le haut ni vers le bas une valeur binaire prédéterminée (1fH).

2. Appareil de commande de véhicule automobile selon la revendication 1,
**caractérisé en ce qu'**
il est conçu comme appareil de commande d'antivol qui commande une fonction importante du véhicule et comporte des moyens qui ne libèrent la fonction importante du véhicule qu'après un contrôle d'autorisation,
tandis que d'autres moyens libèrent la fonction importante du véhicule lors de la mise en route pendant un temps de libération préalable,
le temps de libération préalable (VFZ) étant réduit d'une certaine valeur (X) à chaque mise en route, si le contrôle d'autorisation n'a pas reçu de réponse positive, et
le temps de libération préalable (VFZ) représente l'information enregistrée au moins dans un emplacement de mémoire (23, 24, 25) de la mémoire effaçable et programmable électriquement (EEPROM).
